# FASCICULE DE BREVET EUROPEEN

(11) **EP 2 676 288 B1**
(45) Date de publication et mention de la délivrance du brevet: **09.08.2017**
(21) Numéro de dépôt: 12704281.0
(22) Date de dépôt: 16.02.2012
(51) Int. Cl.: H01L 21/20, H01L 21/683

(54) **PROCEDE DE REALISATION D'UN SUPPORT DE SUBSTRAT**
VERFAHREN ZUR HERSTELLUNG EINER SUBSTRATHALTERUNG
METHOD FOR PRODUCING A SUBSTRATE HOLDER

(30) Priorité: 18.02.2011 FR 1151340
(43) Date de publication de la demande: 25.12.2013
(73) Titulaire: Commissariat à l'Énergie Atomique et aux Énergies Alternatives, 75015 Paris (FR)
(72) Inventeur: FOURNEL, Frank, F-38190 Villard-Bonnot (FR); BALLY, Laurent, F-38450 Saint-Georges-de-Commiers (FR); ZUSSY, Marc, F-38120 Saint-Égrève (FR)
(74) Mandataire: Ahner, Philippe
(86) Numéro de dépôt international: PCT/EP2012/052672
(87) Numéro de publication internationale: WO 2012/110591

(56) Documents cités:
- EP-A2- 1 975 998
- WO-A1-2005/083774
- WO-A1-2010/087226
- WO-A1-2011/018780
- WO-A2-02/095795
- US-A1- 2010 248 444

## Description

### DOMAINE TECHNIQUE ET ART ANTÉRIEUR

La présente invention se rapporte à un procédé de réalisation d'un support de substrat ("holder" en anglais) destiné à servir de logement à un au moins un substrat dont la taille est inférieure à celle des substrats normalement mis en oeuvre dans les procédés microélectronique.

Dans le domaine de la microélectronique et de la nanoélectronique, on effectue différentes opérations sur des substrats, par exemple en silicium. On peut effectuer des dépôts chimiques en phase vapeur. Certaines machines permettant d'effectuer de tels dépôts sont prévues pour des substrats de diamètre de 300 mm. Lorsque le substrat a un diamètre de 200 mm et que l'on souhaite utiliser une machine conçue pour des plaques de 300 mm de diamètre, on utilise un support de substrat ayant un diamètre de 300 mm, qui comporte un logement pour recevoir le substrat de 200 mm, ce support forme un adaptateur pour le substrat.

Il existe plusieurs procédés de fabrication pour réaliser un tel support de substrat.

On peut prévoir de réaliser une empreinte dans une plaque ayant un diamètre adapté aux machines.

L'empreinte peut être réalisée directement par photolithographie et gravure chimique ou ionique. Il est aussi possible de la réaliser avec une machine d'amincissement mécanique comprenant une roue de rectification apte à roder le centre d'un substrat.

Afin de limiter les risques de sortie du substrat de l'empreinte, celle-ci présente une profondeur au moins égale à la moitié de l'épaisseur de la plaque à supporter. Cela a pour conséquence que l'épaisseur de matériau entre le fond de l'empreinte et la face arrière du support est relativement mince ce qui peut poser des problèmes de tenue mécanique du support. Par exemple, pour réaliser un support pour une plaquette de silicium de 200 mm de diamètre et de 725 µm d'épaisseur dans une machine qui utilise des plaques de 300 mm de diamètre et de 750 µm d'épaisseur, une empreinte de 200 mm de diamètre et de 350 µm de profondeur est réalisée dans la plaque de 300 mm de diamètre. Avec une telle empreinte la plaque de 300 mm est alors plus flexible. Cette flexibilité peut alors provoquer une déformation trop importante de la plaque par exemple lors des étapes de chargement et déchargement effectuées par certains robots rendant leur utilisation impossible dans certaines machines. Cette faible épaisseur restante de silicium en dessous de l'empreinte peut même fragiliser très fortement le support de substrat et ce dernier risque alors de casser lors de sa manipulation.

Il est en outre difficile de contrôler le fond de l'empreinte aussi bien en termes de rugosité, de planéité et de propreté. Par exemple, après une étape d'amincissement mécanique tel que décrit ci-dessus, il y a en surface du matériau rodé une zone écrouie de quelques micromètres d'épaisseur qui peut être une source très importante de contamination particulaire empêchant l'utilisation de ce support ainsi réalisé en salle blanche. Dans le cas d'une réalisation par photolithographie et gravure chimique ou ionique, la rugosité et la planéité sont très difficiles à contrôler car il est impossible de reprendre la surface par les techniques classiques de polissage mécano-chimique.

Un autre procédé prévoit de coller sur la surface d'une plaque des pièces en divers matériaux qui immobilisent la plaquette. Se pose alors le problème de reproductibilité du positionnement des pièces et la tenue en température de la colle utilisée, lors du procédé technologique appliqué à la plaquette. WO2005/083774 divulgue un procédé de réalisation d'un support pour un substrat dans lequel deux plaques sont collées par collage direct et une empreinte pour loger ledit substrat est gravée dans une des plaques.

### EXPOSÉ DE L'INVENTION

C'est par conséquent un but de la présente invention d'offrir un procédé de réalisation de support de substrat permettant d'obtenir un bon état de surface du fond des empreintes et d'avoir des supports de substrat offrant une rigidité suffisante.

Le but précédemment énoncé est atteint en collant au moins deux plaques ayant un diamètre adapté aux machines à utiliser et en délimitant l'empreinte sur l'une des plaques, préalablement au collage des deux plaques. Les empreintes sont délimitées sur une face d'une des plaques en réalisant des zones offrant une aptitude réduite, voire nulle au collage direct par rapport au reste de la face. Après collage direct des deux plaques, les portions de plaques délimitées par lesdites zones sont retirées, formant ainsi les empreintes. L'énergie de collage au niveau des zones offrant une aptitude réduite, voire nulle au collage, est inférieure à 200 mJ/m².

Dans un mode de réalisation, les zones sont formées par le périmètre des empreintes réalisé par exemple par un trait de scie.

Dans un autre mode de réalisation, c'est toute la section de l'empreinte qui présente une aptitude réduite, voire nulle au collage, ceci peut être obtenu par exemple en modifiant l'état de surface ou en retirant de la matière.

En d'autres termes, le procédé selon la présente invention met en oeuvre au moins deux plaques d'un premier diamètre, et réalise sur une des plaques des zones où le collage est rendu difficile, voire impossible. On élabore ainsi des surfaces mixtes avec des zones aptes au collage et des zones non aptes au collage et/ou des zones aptes au collage entourées de zones non aptes au collage. Les zones non aptes au collage ou les zones aptes au collage entourées de zones non aptes au collage délimitent les emplacements des futures empreintes. Une fois ces zones non aptes au collage réalisées, on prépare les deux plaques d'un premier diamètre pour les assembler par collage direct. L'interface d'assemblage comporte alors des zones collées et des zones non collées. Les empreintes du support de substrat sont ensuite mises à jour en retirant des blocs de plaque situés à l'aplomb ou à l'intérieur des zones non aptes au collage.

Les supports ainsi réalisés comportant une plaque pleine, leur rigidité est au moins celle d'une plaque classiquement utilisée dans les procédés technologique.

La présente invention a alors pour objet un procédé de réalisation d'un support d'au moins un substrat à partir d'au moins une première et une deuxième plaque selon la revendication 1

De préférence, les empreintes ainsi obtenues ont une profondeur supérieure à 5 µm, voire supérieure à 50 µm ou 10 µm.

Dans un mode de réalisation, lors de l'étape c), i y a une absence de collage au niveau de la zone de collage faible.

Par exemple, la zone de collage faible est formée par au moins un premier trait de scie. La zone de collage faible est par exemple de forme carrée.

Dans un autre mode de réalisation, le procédé comporte une étape de traitement de la surface de sorte qu'elle présente des propriétés de collage inférieures à celles du reste de la première face de la deuxième plaque. L'étape de traitement de la surface peut comporter une étape d'augmentation de la rugosité de ladite surface de telle sorte qu'un collage avec la deuxième face de la première plaque soit empêché. En variante, l'étape de traitement de la surface comporte une étape d'enlèvement de la matière au niveau de ladite surface de sorte à créer un jeu entre ladite surface et la première face de la première plaque.

L'étape d'augmentation de la rugosité ou d'enlèvement de matière pour éviter un contact peut être réalisée par gravure, par exemple avec du tétraméthyle ammonium hydroxyde.

Avantageusement, le procédé peut comporter, préalablement à l'étape a) de délimitation de la au moins une surface , une étape de formation d'un oxyde thermique ou d'une couche de nitrure à la surface d'au moins la deuxième plaque et après l'étape a), une étape de retrait de l'oxyde thermique formé sur la surface , par exemple au moyen d'une solution acide.

L'étape d) peut être obtenue par réalisation de deuxièmes traits de scie dans la deuxième face de la deuxième plaque au droit des premiers traits de scie jusqu'à rejoindre les premiers traits de scie et à libérer un bloc de matière de la deuxième plaques situé à l'aplomb de la surface . Les premiers traits de scie sont par exemple repérés par observation infrarouge ou acoustique.

En variante, l'étape d) est obtenue par amincissement de la deuxième plaque à partir de sa deuxième face jusqu'à rejoindre le ou les premiers traits de scie et à libérer un bloc de matière de la deuxième plaque situé à l'aplomb de la surface.

La présente invention a également pour objet un procédé de réalisation d'un support d'au moins un substrat à partir d'au moins une première, une deuxième plaque et une troisième plaque selon la revendication 10.

Le procédé peut comporter, préalablement à l'assemblage de la deuxième et troisième plaque, la formation d'une couche d'oxyde thermique à la surface d'au moins la deuxième et troisième plaque.

Par exemple, le collage entre la deuxième face de la deuxième plaque et une première face de la troisième plaque est un collage hydrophile et le collage entre la première face de la deuxième plaque et la deuxième face de la première plaque est un collage hydrophobe.

Le procédé peut comporter, après l'assemblage de la deuxième et de la troisième plaque, le retrait des couches d'oxyde d'au moins les deuxième et troisième plaques.

Dans ce mode de réalisation, les premiers traits de scie ont de préférence une profondeur inférieure à l'épaisseur de la deuxième plaque.

L'étape d) peut être t obtenue en exerçant un effort de séparation entre la première face de la troisième plaque et de la deuxième face de la deuxième plaque à une extrémité latérale de l'empilement de la deuxième et de la troisième plaque.

Avantageusement, lors de l'étape a) plusieurs surfaces sont délimitées.

Par exemple, les plaques ont un diamètre compris entre 100 mm et 450 mm et une épaisseur comprise entre 525 µm et 1000 µm.

De manière avantageuse, le au moins un premier trait de scie et/ou un deuxième trait de scie sont orientés à 45° des plans cristallins de la deuxième et/ou de la troisième plaque.

### BRÈVE DESCRIPTION DES DESSINS

La présente invention sera mieux comprise à l'aide de la description qui va suivre et des dessins en annexes sur lesquels :
- les figures 1A à 1F sont des représentations schématiques de différentes étapes de réalisation d'un mode de réalisation d'un procédé de fabrication d'un support de substrat,
- les figures 2A à 2F sont des représentations schématiques de différentes étapes de réalisation d'un autre mode de réalisation d'un procédé de fabrication d'un support de substrat,

- les figures 3A à 3E sont des représentations schématiques de différentes étapes de réalisation d'un autre mode de réalisation d'un procédé de fabrication d'un support de substrat,
- la figure 4 est une représentation schématique d'une vue de dessus d'un support de substrat obtenu grâce par les procédés des figures 1A à 3E.

### EXPOSÉ DÉTAILLÉ DE MODES DE RÉALISATION PARTICULIERS

Les procédés de réalisation qui vont être décrits permettent de réaliser des supports pour un ou plusieurs substrat(s), de préférence de plusieurs substrats. Chaque procédé met en oeuvre au moins deux plaques de grand diamètre, ce grand diamètre correspond à un diamètre adapté aux machines destinées à réaliser les procédés technologiques sur les substrats à supporter. Les plaques de grand diamètre peuvent par exemple être des plaques de silicium de 300 mm de diamètre et de 750 µm d'épaisseur. L'empreinte peut alors être dimensionnée pour contenir une plaquette de 200 mm de diamètre et de 750 µm d'épaisseur. Typiquement le diamètre de plaque de grand diamètre peut aller de 100 mm à 450 mm, leur épaisseur typiquement de 525 µm à 1000 µm. Une des deux plaques peut être amincie après le collage direct pour obtenir une épaisseur comprise entre 5 µm et l'épaisseur avant collage. Concernant l'empreinte, typiquement on peut la dimensionner pour contenir de plaques allant de 50 mm à 300 mm avec des épaisseurs allant de 5 µm à 750 µm. Les différentes plaques peuvent être en silicium, en Germanium, AsGa, InP, Saphir, SiC, Silice fondue, en verre, GaN. Les empreintes ont une profondeur supérieure à 5 µm, voire supérieure à 50 µm ou 10 µm.

Les procédés selon l'invention qui vont être décrits sont décrits en vue de la fabrication d'un support de substrat de 300 mm de diamètre pour recevoir des plaquettes de 50 mm de diamètre. Le support est réalisé à partir de plaques de 300 mm de diamètre et de 750 µm d'épaisseur.

Les plaques de grand diamètre seront désignées par la suite "plaque" et les plaques de petit diamètre seront désignées par la suite "plaquette".

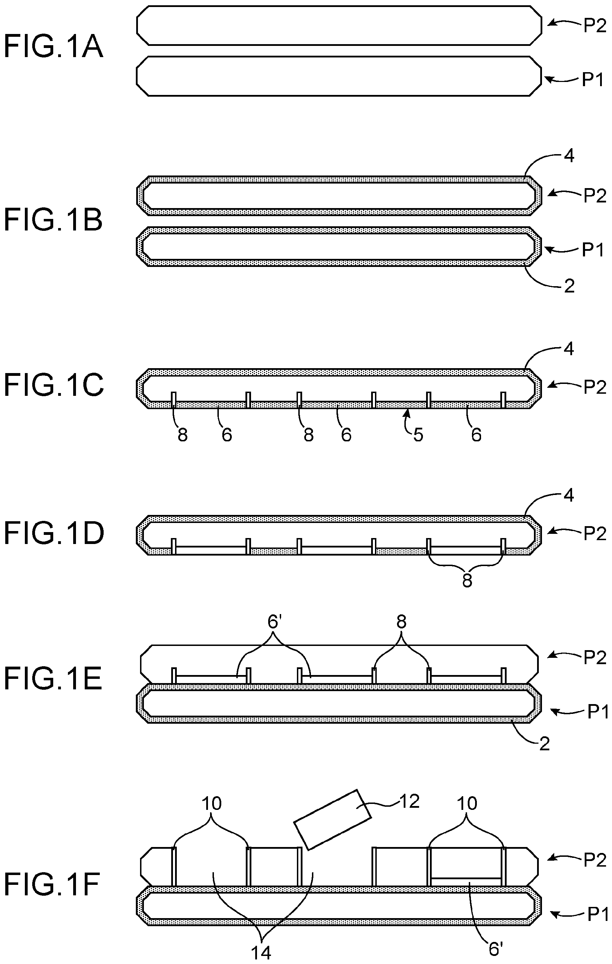

Lors d'une première étape représentée sur la figure 1A, on prend deux plaques P1, P2 de même diamètre, par exemple en silicium monocristallin.

Lors d'une étape suivante représentée sur la figure 1B, on génère à la surface de la plaque P2 une couche 4 respectivement destinée à permettre une gravure sélective du silicium. La couche 4 est par exemple une couche d'oxyde thermique.

Avantageusement, une couche d'oxyde thermique est également formée sur la plaque P2 qui, permet de faciliter le collage direct. Les couches d'oxyde thermique sont par exemple obtenues sous atmosphère oxydante, par exemple au moyen de vapeur d'eau, à une température comprise entre 930°C et 970°C par exemple égale à 950°C. Les couches 2, 4 ont par exemple une épaisseur comprise entre 100 nm et 200 nm, par exemple égale à 150 nm.

En variante, on peut utiliser d'autres couches présentant une sélectivité de gravure par rapport au matériau de la plaque P2 : par exemple, une couche de nitrure pour une plaque en silicium.

Lors d'une étape suivante représentée sur la figure 1C, on délimite sur une des faces 5 de la plaque P2, dite face avant, des zones 6 correspondant à l'emplacement des empreintes destinées à recevoir les plaquettes. Ces délimitations sont obtenues en réalisant des traits de scie 8 à travers la couche 4 de sorte à traverser la couche d'oxyde 4 et à entailler le silicium. Par exemple les traits de scie ont une profondeur comprise entre 125 µm et 175 µm par exemple égale à 150 µm, avec une largeur comprise entre 100 µm et 200 µm, par exemple 150 µm.

Les délimitations ont par exemple une forme de carré dont la longueur des côtés est légèrement supérieure au diamètre des plaquettes. Par exemple, la longueur des côtés du carré est comprise entre 50,5 mm et 51,5 mm, par exemple égal à 51 mm pour loger une plaquette de diamètre 50 mm.

Un jeu de 1 mm +/-0,5 mm est un jeu suffisant pour faciliter la mise en place des futures plaquettes sans pour autant leur donner trop de possibilité de mouvement

De manière avantageuse, les traits de scie sont orientés à 45° des plans cristallins afin de limiter la fragilité de la plaque.

Dans l'exemple décrit, les empreintes sont de forme carrée, cependant on pourrait prévoit de réaliser des empreintes de forme circulaire en réalisant un trait de scie circulaire.

Les traits de scie peuvent être faits par une lame rotative. Par exemple des scies pour plaque de silicium adaptées à la présente invention sont vendues commercialement par exemple par la société DISCO.

Lors d'une étape suivante représentée sur la figure 1D, la couche d'oxyde est retirée à l'intérieur des zones délimitées par les traits de scie 8, par exemple en versant sur ces zones de l'acide fluorhydrique. Grâce aux traits de scie 8, l'acide est confiné à l'intérieur des zones et n'attaque pas la couche d'oxyde entre les zones 6. Dans les zones 6, le silicium est mis à nu. Dans le cas d'une couche de nitrure, on utilise de l"acide orthophosphorique pour retirer la couche de nitrure.

Lors d'une étape suivante, on plonge la deuxième plaque P2 dans une solution apte à graver le silicium des zones 6, par exemple il s'agit de tétraméthyle ammonium hydroxyde (TMAH) à une température de 80°C. Le TMAH ne grave pas le silicium protégé par l'oxyde. En variante, la solution de gravure peut être du KOH. Le KOH et le TMAH sont utilisables avec une couche de protection en nitrure.

La profondeur de la gravure dépend du temps pendant lequel la deuxième plaque P2 reste immergée dans la solution. Par exemple, pour un temps d'immersion de 30 minutes, le silicium est gravé sur une profondeur comprise ente 5 µm et 15 µm, par exemple égale à 10 µm. La gravure n'a pas besoin d'être très profonde, une profondeur de quelques µm est suffisante pour éviter le collage. Une gravure peu profonde permet en outre un gain de temps, et de minimiser l'épaisseur de la couche protectrice requise. En outre, on évite de fragiliser la plaque.

La deuxième plaque P2 obtenue à la fin de cette étape, est représentée sur la figure 1E, elle comporte alors des zones 6' dont le fond est en retrait de la surface de la plaque

Lors d'une étape suivante, on retire le reste de la couche d'oxyde sur la deuxième plaque P2, par exemple en la plongeant dans un bain d'acide fluorhydrique. Cela permet de retirer la surface de la couche protectrice qui a vu l'attaque chimique et de retrouver une surface apte au collage.

Lors d'une étape suivante représentée sur la figure 1F, on colle la première P1 et la deuxième P2 plaque. Pour cela, on effectue préalablement un nettoyage des surfaces à mettre en contact. Par exemple, le nettoyage peut être obtenu par voie chimique comme suit :
On nettoie avec une solution de H₂SO₄/H₂O₂ 3:1 à 180°C pendant 10 mn, on effectue ensuite un rinçage pendant 10 mn à l'eau désionisée. On effectue un second nettoyage avec une solution de NH₄OH/H₂O₂/H₂O 1:1:5 à 70°C pendant 10 mn, puis un nouveau rinçage à l'eau désionisée pendant 10 mn.

La couche d'oxyde sur la plaque P1 pourrait être retirée. Cependant comme cela a été expliqué précédemment, elle peut faciliter le collage.

On met ensuite en contact la face avant de la deuxième plaque avec l'une des faces de la première plaque et on réalise un collage direct.

On entend par "collage direct" un collage par adhésion moléculaire au cours duquel deux surfaces planes adhèrent l'une à l'autre sans application de colle.

Le collage s'effectue avantageusement à température et pression ambiante. La rugosité des surfaces est de préférence inférieure à 0,5nm RMS.

Le collage a lieu entre la face avant de la deuxième plaque P2 et la face avant de la première plaque P1 sauf au niveau des zones 6' qui se trouvent en retrait par rapport à la surface de face avant 5 du fait du retrait de silicium.

Avantageusement, afin de renforcer le collage, on effectue un recuit par exemple à 1100°C pendant 2 h.

Lors d'une étape suivante, on repère les zones 6' par une technique de caractérisation, par exemple par observation infrarouge ou acoustique. Des traits de scie 10 au droit des traits de scie 8 sont ensuite réalisés en face arrière de la deuxième plaque P2. La profondeur des deuxièmes traits de scie 10 est telle que les deuxièmes traits de scie rejoignent les premiers traits de scie. Dans le cas où les premiers traits de scie 6 ont une profondeur de 150 µm et la deuxième plaque P une épaisseur initiale de 750 µm, on réalise des deuxièmes traits de scie ayant une profondeur de 650 µm. Des blocs 12 de silicium de section carrée sont alors libérés. Ces blocs 12 sont retirés et on obtient des empreintes carrées 14 aptes à recevoir et à immobiliser des plaquettes de 50 mm de diamètre. Pour retirer les bloques, la structure est par exemple retournée et les blocs chutent par gravité, ou ils peuvent être saisis avec un système générant une dépression tel qu'une précelle à vide. Dans le cas où seule la périphérie de l'empreinte présente un collage faible, un exerce un effort pour rompre l'interface de collage par exemple au moyen d'une précelle à vide.

L'état de surface, en termes de rugosité et de planéité, du fond des empreintes est celui de la couche d'oxyde 2 de la première plaque qui correspond sensiblement à l'état de surface initial de la première plaque P1.

On peut prévoir un rinçage du fond des empreintes, par exemple avec une douchette sous pression d'eau désionisée.

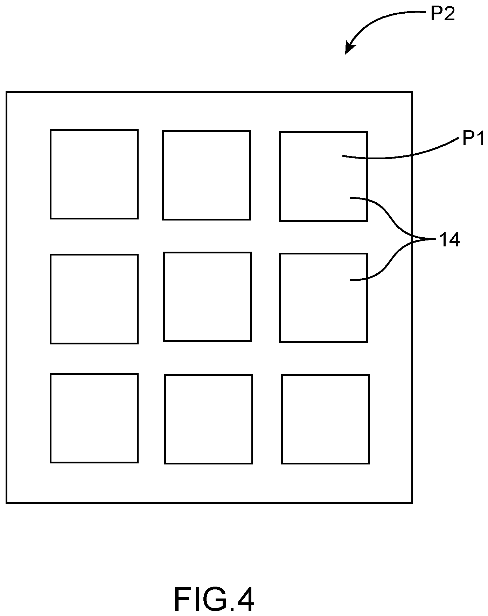

Sur la figure 4, on peut voir une vue de dessus d'un tel support de substrat ainsi obtenu.

En variante, il est possible au lieu de retirer de la matière de telle sorte qu'il y ait un jeu entre le fond des zones à l'aplomb de l'empreinte, de créer une rugosité suffisante pour éviter un collage entre ces surfaces et la première plaque. Cette rugosité peut être obtenue par un bain de TMAH.

On peut également envisager de délimiter les zones 6 par une zone formant le périmètre de l'empreinte présentant une rugosité suffisante pour éviter un collage, au lieu d'un ou de plusieurs traits de scie. Cette zone de rugosité suffisante forme une surface à collage faible.

Ainsi, au lieu de réaliser des zones où le collage est empêché, on réalise des zones de collage présentant une énergie de collage faible par rapport au reste de la surface. Dans la présente demande, on entend par collage faible un collage dont l'énergie de collage est inférieure à 200 mJ/m².

De manière générale, les surfaces des zones de collage fort et les surfaces des zones de collage faible subissent des préparations de surface et/ou de rugosité différentes de sorte que l'on obtienne un collage fort, i.e. présentant une énergie de collage supérieure à 200 mJ/m² au niveau des zones devant rester collées, et un collage faible, i.e. présentant une énergie de collage inférieure à 200 mJ/m² au niveau des zones où les blocs sont à éliminer.

Une telle énergie peut être obtenue typiquement par collage hydrophobe, qui offre une énergie de collage réduite.

Elle peut également être obtenue par collage hydrophile. Pour cela, la surface est par exemple préparée de sorte à limiter le nombre de groupement OH en surface, qui sont responsables du collage. Ceci peut être obtenu en choisissant de manière adaptée la chimie de préparation.

En variante, la rugosité peut également intervenir. A titre d'exemple, dans le cas d'un collage entre une surface de SiO₂ ou une surface de silicium recouverte d'un oxyde natif, une rugosité inférieure à 0,3 Angström RMS (mesurée par AFM sur une surface de 1µm×1µm) permettre d'obtenir une énergie inférieure à 200 mJ/m².

La réalisation d'une rugosité pour obtenir une zone à faible niveau de collage peut être obtenue de la manière suivante :
- après avoir mis à nu les surfaces de silicium au niveau des zones 6 d'en modifier la rugosité en utilisant du TMAH (comme pour la gravure) mais à une température plus faible, par exemple entre 50 et 60, ce qui a pour effet de créer une rugosité sans entrainer un retrait de matière trop important. En variante, un traitement SC1 (NH4OH, H2O2, H2O) est également possible. Le traitement à l'acide fluorhydrique subséquent qui est réalisé pour éliminer l'oxyde, a également pour effet d'augmenter l'hydrophobie sur les zones de silicium « rugueuses », limitant encore la force du collage au niveau de ces zones.

Par ailleurs, l'étape de recuit est adaptée de sorte que l'énergie de collage au niveau de la zone de collage faible reste inférieure à 200 mJ/m². Alternativement, l'étape de recuit peut être supprimée.

Enfin, on peut prévoir après élimination des blocs de réaliser un traitement thermique renforçant le collage au niveau des zones de collage fort.

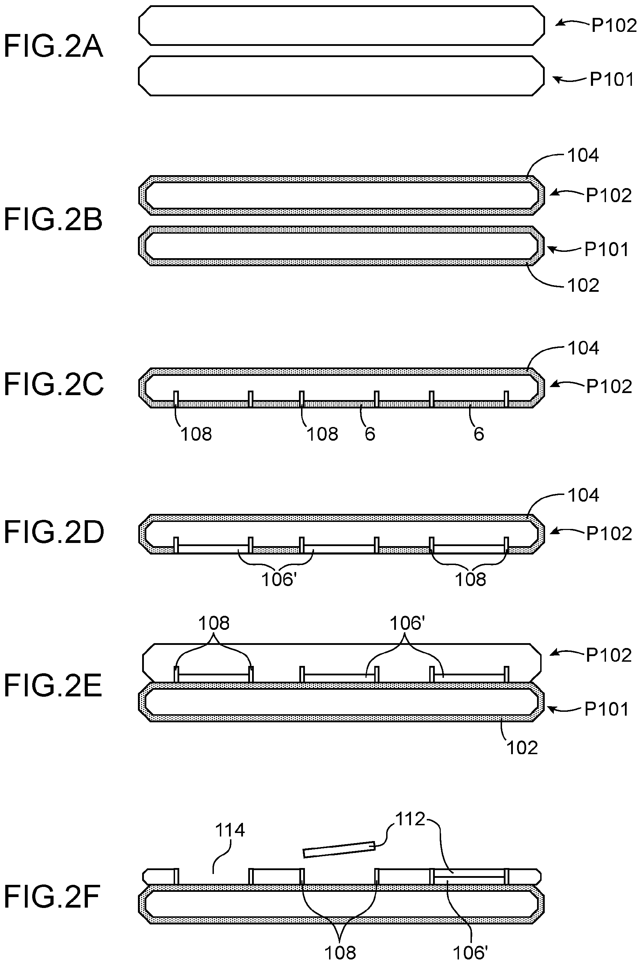

Sur les figures 2A à 2F, on peut voir représentées schématiquement les étapes d'un autre mode de réalisation d'un procédé de réalisation d'un support de substrat. Les étapes de procédé de fabrication sont similaires à celles du procédé décrit ci-dessus jusqu'à l'étape d'assemblage des première P101 et deuxième P102 plaques comprise.

Les plaques subissent une oxydation et sont recouvertes d'une couche d'oxyde 102, 104 respectivement (figure 2B).

Les zones 106 sont ensuite délimitées par des traits de scie 108 (figure 2C).

Les zones sont gravées pour donner des zones en retrait 106' (figure 2D).

Les plaques P101, P102 sont assemblées, par leurs faces avant (figure 2E).

La révélation des empreintes 114 est obtenue dans ce procédé en réalisant un amincissement de la face arrière de la deuxième plaque P102 de sorte à rejoindre les traits de scie 108 qui ont été réalisés en face avant de la deuxième plaque P102. Dans le cas où les traits de scie ont une profondeur de 750 µm, on enlève environ 350 µm. Lorsque suffisamment de matière a été enlevée, les blocs 112 délimités par les traits de scie 108 sont libérés. En retirant ces derniers, on obtient des empreintes de section carrée de 50 µm de côté apte à recevoir des plaquettes de 50 µm de diamètre.

Cet amincissement peut se faire par rodage et/ou par une attaque chimique. Dans le cas d'une attaque chimique, la première plaque P101 est protégée.

Les blocs sont retirés comme dans le cas du mode de réalisation précédent par exemple en retournant la structure ou en les aspirant.

Ce mode de réalisation permet une révélation simultanée de toutes les empreintes, puisque l'amincissement est réalisé sur toute la face arrière simultanément. En outre, il ne nécessite aucune connaissance exacte de la localisation des futures empreintes, contrairement au procédé précédemment décrit.

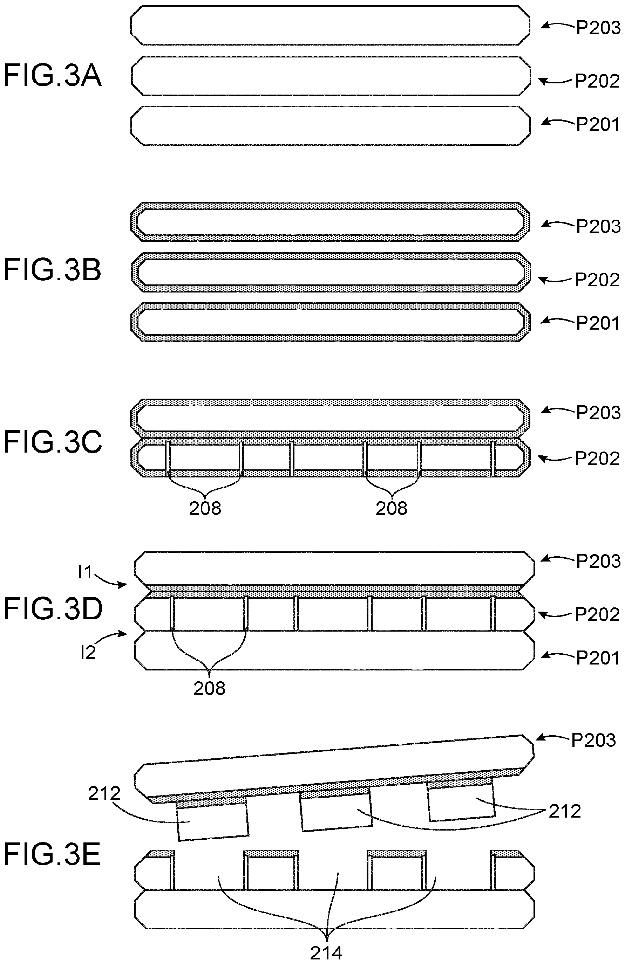

Sur les figures 3A à 3E, on peut voir un autre mode de réalisation d'un procédé de fabrication d'un support de substrat. Ce procédé se distingue des deux modes de réalisation précédemment décrits en ce qu'il met en oeuvre trois plaques.

Lors d'une première étape représentée sur la figure 3A, on prend trois plaques P201, P202, P203 de même diamètre, par exemple en silicium monocristallin.

Lors d'une étape suivante représentée sur la figure 3B, on forme une couche d'oxyde thermique sur les plaques P202 et P203, par exemple en plaçant les plaques à 950°C sous une atmosphère oxydante. Une couche d'oxyde thermique peut également être formée sur la plaque P201.

Les faces avant et faces arrière des plaques sont recouvertes d'oxyde thermique.

Lors d'une étape suivante, on assemble la troisième plaque P203 et la deuxième plaque P202 en collant la face avant de la troisième plaque P203 sur la face arrière de la deuxième plaque P202.

Le collage est par exemple direct. Il est par exemple de type hydrophile. Pour cela, on peut effectuer préalablement au collage le nettoyage suivant des faces à coller: on nettoie la face avant de la troisième plaque P203 et la face arrière de la deuxième plaque P202 avec une solution de H₂SO₄/H₂O₂ 3:1 à 180°C pendant 10 mn. On rince ensuite les faces pendant 10 mn à l'eau désionisée. On effectue un second nettoyage avec une solution de NH₄OH/H₂O₂/H₂O 1:1:5 à 70°C pendant 10 mn, puis un nouveau rinçage à l'eau désionisée pendant 10 mn.

Les couches d'oxyde sur les deuxième et troisième plaques permettent de réaliser un collage hydrophile. Le collage ainsi réalisé présente une première énergie qui sera désignée par la suite "forte".

Lors d'une étape suivante, on réalise sur la face avant de la deuxième plaque P202, des traits de scie formant par exemple des carrés de 51 mm, ces carrés étant répartis sur la surface de la face avant.

Il est également avantageux de réaliser des traits de scie orientés à 45° des plans cristallins afin de limiter la fragilité de la plaque.

De préférence, les traits de scie 208 ne traversent pas toute l'épaisseur de la deuxième plaque 202, i.e. ils n'atteignent pas la troisième plaque P203 afin de réduire les risques de fragilisation de la troisième plaque P203. On peut par exemple laisser une épaisseur de 10 µm de la deuxième plaque P202 en fond de traits de scie. L'assemblage à la fin de cette étape est représenté sur la figure 3C.

Cependant, on peut envisager que les traits de scie 208 traversent toute la deuxième plaque P202 sans entamer la troisième plaque P203. Dans ce cas, les traits de scie ont une profondeur d'environ 750 µm. Un procédé, dans lequel les traits de scie entameraient le troisième plaque, ne sort pas du cadre de la présente invention.

Lors d'une étape suivante, on désoxyde l'assemblage de deuxième P202 et troisième P203 plaque. On désoxyde également la première plaque P201 même si elle n'a pas subi l'étape de formation d'une couche d'oxyde, afin d'enlever l'oxyde natif. De manière avantageuse, la désoxydation est obtenue par un bain d'acide fluorhydrique. Lors d'une étape suivante, on assemble l'assemblage des deuxième P202 et troisième P203 plaque avec la première plaque P201 en collant la face avant de la deuxième plaque P202 avec la face avant de la première plaque P201 de sorte que l'énergie de liaison entre les deux faces soit inférieure à l'énergie de liaison entre la deuxième P202 et la troisième P203 plaque. Cette énergie sera désignée "énergie faible".

La désoxydation à l'aide de l'acide fluorhydrique a pour effet de passiver par l'hydrogène les faces avant des première et deuxième plaques, ce qui permet de réaliser un collage hydrophobe.

L'ensemble ainsi obtenu est représenté sur la figure 3D.

En variante, il est possible de remplacer le collage hydrophobe par un collage hydrophile dégradé en modifiant la rugosité des surfaces. Il est aussi possible d'augmenter l'énergie de collage du premier collage hydrophile en réalisant un recuit de la première structure collée et/ou un traitement de surface spécifique comme une activation plasma.

Dans le cas où on réalise un collage hydrophile I1 entre la deuxième P202 et la troisième P2063 plaque et un collage hydrophobe I2 entre la première P201 et la deuxième P202 plaque, on peut faire subir un recuit thermique à l'ensemble à 400°C pendant 2 h. Le recuit renforce les énergies du collage hydrophile et du collage hydrophobe, cependant ce renforcement est plus marqué pour le collage hydrophile que pour le collage hydrophobe, le recuit présente donc l'avantage d'amplifier la différence d'énergie de collage des deux interfaces.

Lors d'une étape suivante, on décolle la troisième plaque P203, par exemple en insérant un coin entre la face avant de la troisième plaque P203 et la face arrière de la deuxième plaque P202. Lorsque la zone de décollement atteint un trait de scie 208, le décollement se produit au niveau de l'interface I2 dont l'énergie est la plus faible. Par conséquent la deuxième plaque P202 se sépare de la première plaque P201, les blocs 212 de la deuxième plaque P202 qui se trouvent à l'intérieur des traits de scie 208 sont emportés avec la troisième plaque P203, comme cela est schématisé sur la figure 3E. On obtient ainsi des empreintes 214 pouvant accueillir des plaquettes de 50 mm de diamètre. L'état de surface du fond des empreintes après le décollement est le même qu'avant collage.

En variante, les zones de forme carrée délimitées entre les traits de scie peuvent être rendue non aptes au collage. Ainsi lors du décollement de la troisième plaque, les blocs de la deuxième plaque à l'aplomb des zones non collées de la deuxième plaques sont emportés avec la troisième plaque, il n'est alors pas nécessaire de gérer des interfaces avec des énergies de collage forte et faible. En outre, l'état de surface du fond des empreintes est celui de la première plaque P201.

Pour alléger le support de substrat, il est avantageux de réaliser un grand nombre d'empreintes ou de grandes empreintes qui ne seront pas forcément utilisées pour loger une plaquette.

On peut envisager d'utiliser des plaques en matériaux différents, par exemple dans le cas de trois plaques pour avoir des énergies de collage différentes.

Grâce aux procédés selon l'invention, on obtient un support de substrat comportant une ou plusieurs empreintes avec un très bon contrôle de la profondeur de l'empreinte puisque cette profondeur correspond à l'épaisseur d'une des deux plaques ou d'une épaisseur très bien contrôlée dans le cas de l'amincissement.

Si l'on désire modifier cette profondeur, soit on utilise une deuxième plaque plus mince ou plus épaisse ou alors on modifie l'amincissement requis en modifiant la profondeur des traits de scie.

On choisira de préférences une profondeur d'empreinte égale à l'épaisseur de la plaquette à supporter pour assurer un très bon maintien de celle-ci.

En outre, les supports ainsi réalisés comportent une plaque pleine dans laquelle aucun trait de scie n'a été réalisé, ils offrent donc une bonne rigidité.

La propreté et la rugosité du fond de l'empreinte sont également très bien contrôlées, car avantageusement tous les traitements de surface pour élaborer la surface mixte sont sur l'autre plaque.

Grâce à l'invention, la rugosité peut être suffisamment faible pour permettre le collage de la plaquette sur le fond de l'empreinte par capillarité ou par collage direct. Cette possibilité de collage est particulièrement avantageuse car il devient envisageable de mettre le support de substrat à la vertical, voire même de le retourner pendant le transport et/ou le traitement de la plaquette sans qu'il soit nécessaire de rajouter de éléments de maintien en face avant de la plaquette. L'ensemble de la surface de la plaquette reste alors accessible même avec un support de substrat retourné.

On peut envisager que la surface de la première plaque ou une couche enterrée qui serait mise à nue comporte des propriétés intéressantes facilitant les étapes technologiques sur la plaquette. La surface ou la couche peut comporter un matériau isolant thermique, comme par exemple de l'oxyde de silicium, ou un matériau conducteur thermique (si on enlève la couche d'arrêt et que l'on se retrouve sur le matériau de la deuxième plaque de grand diamètre qui pourrait être en silicium ou en un autre matériau bon conducteur thermique). Cette couche peut alors faciliter l'évacuation de chaleur lors d'étapes réalisées sur la plaquette. La surface ou la couche enterrée peut en variante être conductrice pour faciliter l'évacuation de charge électrique par exemple.

Les propriétés de conduction thermique ou électrique seront amplifiées si la plaquette est collée, par exemple par collage direct, sur le fond de l'empreinte.

On peut prévoir de déposer des couches conductrices électriques ou isolantes électriques et/ou des couches conductrices thermiques ou isolantes thermique peuvent avant ou après le collage direct de la première et de la deuxième plaque.

Afin de faciliter la préhension de la plaquette logée dans l'empreinte, les empreintes peuvent présenter une géométrie complexe voir débouchantes sur un bord de la première plaque, pour permettre par exemple le passage d'une précelle à vide ou d'un robot.

Il est bien entendu que les empreintes peuvent avoir une autre forme par exemple en forme de disque, de polygone tel qu'un triangle ou toute autre forme.

En variante, il est envisageable d'utiliser une première plaque ayant le diamètre adapté aux machines dans lesquelles les structures sont destinées à être traitées et des deuxième et troisième plaques de diamètre plus petit.

## Revendications

1. Procédé de réalisation d'un support d'au moins un substrat, ledit support comportant au moins une empreinte pour loger ledit substrat, à partir d'au moins une première plaque (P1, P101) et une deuxième (P2, P102) plaque comprenant chacune des première et deuxième faces planes parallèles, comportant les étapes :
a)
a1) délimitation uniquement sur la première face plane de la deuxième plaque (P2, P102) d'au moins une surface (6, 106) au moyen d'une zone présentant, avec une face de la première plaque (P1, P101), une énergie de collage au niveau de la zone de collage faible inférieure à 200 mJ/m², dite zone de collage faible, ladite surface étant celle de l'empreinte à réaliser, et
a2) traitement de ladite surface (6, 106) de sorte qu'elle présente des propriétés de collage inférieures à celles du reste de la première face de la deuxième plaque,
b) mise en contact de la première face de la deuxième plaque (P2, P102) avec la deuxième face de la première plaque (P1, P101),
c) collage direct entre lesdites première et deuxième faces,
d) retrait de la portion de la deuxième plaque (P2, P102) située à l'aplomb de ladite surface à l'intérieur de la zone de collage faible.

2. Procédé selon la revendication 1, dans lequel lors de l'étape c), il y a une absence de collage au niveau de la zone de collage faible.

3. Procédé selon la revendication 1 ou 2, dans lequel la zone de collage faible est formée par au moins un premier trait de scie (8, 108),le au moins un premier trait de scie étant avantageusement orienté à 45° des plans cristallins de la deuxième plaque.

4. Procédé selon l'une des revendications 1 à 3, , dans lequel le traitement de ladite surface comporte une étape d'augmentation de la rugosité de ladite surface de telle sorte qu'un collage avec la deuxième face de la première plaque est empêché.

5. Procédé selon l'une des revendications 1 à 3, dans lequel le traitement de ladite surface (6) comporte une étape d'enlèvement de la matière au niveau de ladite surface de sorte à créer un jeu entre ladite surface et la première face de la première plaque (P1).

6. Procédé selon la revendication 4 ou 5, dans lequel l'étape d'augmentation de la rugosité ou d'enlèvement de matière pour éviter un contact est réalisée par gravure, par exemple avec du tétraméthyle ammonium hydroxyde.

7. Procédé selon l'une des revendications 1 à 6, comportant, préalablement à l'étape a) de délimitation de la au moins une surface, une étape de formation d'un oxyde thermique ou d'une couche de nitrure à la surface d'au moins la deuxième plaque et après l'étape a), une étape de retrait de l'oxyde thermique formé sur la surface, par exemple au moyen d'une solution acide.

8. Procédé selon l'une des revendications 1 à 7 en combinaison avec la revendication 3, dans lequel l'étape d) est obtenue par réalisation de deuxièmes traits de scie (10) dans la deuxième face de la deuxième plaque (P2) au droit des premiers traits de scie (8) jusqu'à rejoindre les premiers traits de scie (8) et à libérer un bloc de matière de la deuxième plaques (P2) situé à l'aplomb de la surface (6), les deuxième traits de scie étant avantageusement orientés à 45° des plans cristallins de la deuxième plaque.

9. Procédé selon l'une des revendications 1 à 7 en combinaison avec la revendication 3, dans lequel l'étape d) est obtenue par amincissement de la deuxième plaque (P102) à partir de sa deuxième face jusqu'à rejoindre le ou les premiers traits de scie (108) et à libérer un bloc de matière de la deuxième plaque (P102) situé à l'aplomb de la surface (106).

10. Procédé de réalisation d'un support d'au moins un substrat, ledit support comportant au moins une empreinte pour loger ledit substrat, à partir d'au moins une première plaque (P201), une deuxième plaque (P202) et une troisième plaque (P203), comprenant chacune des première et deuxième faces planes parallèles, comportant les étapes :
a) délimitation uniquement sur la première face plane de la deuxième plaque (P202) d'au moins une surface (206) au moyen d'une zone présentant, avec une face de la première plaque (P201), une énergie de collage au niveau de la zone de collage faible inférieure à 200 mJ/m2, dite zone de collage faible, ladite surface étant celle de l'empreinte à réaliser,
b) mise en contact de la première face de la deuxième plaque (P202) avec la deuxième face de la première plaque (P201),
c) collage direct entre lesdites première et deuxième faces,
d) retrait de la portion de la deuxième plaque (P202) située à l'aplomb de ladite surface à l'intérieur de la zone de collage faible, en décollant la troisième plaque (P203),
ledit procédé comportant préalablement à l'étape a) une étape d'assemblage de la deuxième plaque (P202) et de la troisième plaque (P203) par collage direct entre la deuxième face de la deuxième plaque (P202) et la première face de la troisième plaque (P203), ledit collage direct offrant une énergie de liaison supérieure à l'énergie de liaison entre la première face de la deuxième plaque (P202) et la deuxième face de la première plaque (P202) en dehors de la zone de collage faible.

11. Procédé selon la revendication 10, comportant, préalablement à l'assemblage de la deuxième (P202) et troisième plaque (P203), la formation d'une couche d'oxyde thermique à la surface d'au moins la deuxième (P202) et troisième (P203) plaque, le collage entre la deuxième face de la deuxième plaque (P202) et une première face de la troisième plaque (P203) étant avantageusement un collage hydrophile et le collage entre la première face de la deuxième plaque (P202) et la deuxième face de la première plaque (P201) étant avantageusement un collage hydrophobe.

12. Procédé selon la revendication 10 ou 11 comportant, après l'assemblage de la deuxième (P202) et de la troisième (P203) plaque, le retrait des couches d'oxyde d'au moins les deuxième (P202) et troisième (P203) plaques.

13. Procédé selon la revendication 10, 11 ou 12, dans lequel la zone de collage faible est formée par au moins un premier trait de scie (208), le au moins un premier trait de scie étant avantageusement orienté à 45° des plans cristallins de la deuxième plaque.

14. Procédé selon la revendication 13, dans lequel les premiers traits de scie (208) ont une profondeur inférieure à l'épaisseur de la deuxième plaque (P202).

15. Procédé selon l'une des revendications 10 à 14, dans lequel l'étape d) est obtenue en exerçant un effort de séparation entre la première face de la troisième plaque (P203) et de la deuxième face de la deuxième plaque (P202) à une extrémité latérale de l'empilement de la deuxième (P202) et de la troisième (P203) plaque.

16. Procédé selon l'une des revendications 1 à 15, dans lequel lors de l'étape a) plusieurs surfaces sont délimitées.

## Patentansprüche

1. Verfahren zur Realisierung eines Trägers für wenigstens ein Substrat, wobei der Träger wenigstens eine Vertiefung umfasst, um das Substrat aufzunehmen, ausgehend von wenigstens einer ersten Platte (P1, P101) und einer zweiten Platte (P2, P102), die jeweils erste und zweite planparallele Flächen umfassen, umfassend die folgenden Schritte:
a)
a1) Begrenzen, ausschließlich auf der ersten planen Fläche der zweiten Platte (P2, P102), wenigstens einer Oberfläche (6, 106) mittels einer Zone, die mit einer Fläche der ersten Platte (P1, P101) eine Klebeenergie im Bereich der Schwachklebezone von weniger als 200 mJ/m² aufweist, genannt Schwachklebezone, wobei die Oberfläche jene der zu realisierenden Vertiefung ist, und
a2) Bearbeiten der Oberfläche (6, 106) derart, dass sie Klebeeigenschaften aufweist, die geringer sind als jene des Rests der ersten Fläche der zweiten Platte,
b) Inkontaktbringen der ersten Fläche der zweiten Platte (P2, P102) mit der zweiten Fläche der ersten Platte (P1, P101),
c) direktes Verkleben zwischen der ersten und der zweiten Fläche,
d) Entfernen des Bereichs der zweiten Platte (P2, P102), der lotrecht zur Oberfläche im Inneren der Schwachklebezone angeordnet ist.

2. Verfahren nach Anspruch 1, bei dem während des Schritts c) keine Verklebung im Bereich der Schwachklebezone erfolgt.

3. Verfahren nach Anspruch 1 oder 2, bei dem die Schwachklebezone durch wenigstens einen ersten Sägeschnitt (8, 108) gebildet wird, wobei der wenigstens eine erste Sägeschnitt vorzugsweise unter 45° zu den Kristallebenen der zweiten Platte orientiert ist.

4. Verfahren nach einem der Ansprüche 1 bis 3, bei dem die Bearbeitung der Oberfläche einen Schritt der Erhöhung der Rauigkeit der Oberfläche derart umfasst, dass eine Verklebung mit der zweiten Fläche der ersten Platte verhindert wird.

5. Verfahren nach einem der Ansprüche 1 bis 3, bei dem die Bearbeitung der Oberfläche (6) einen Schritt des Entfernens des Materials im Bereich der Oberfläche derart umfasst, dass ein Spiel zwischen der Oberfläche und der ersten Fläche der ersten Platte (P1) erzeugt wird.

6. Verfahren nach Anspruch 4 oder 5, bei dem der Schritt des Vergrößerns der Rauigkeit oder des Entfernens des Materials zur Vermeidung eines Kontakts durch Ätzen realisiert wird, beispielsweise mit Tetramethylammoniumhydroxid.

7. Verfahren nach einem der Ansprüche 1 bis 6, umfassend vor dem Schritt a) der Begrenzung der wenigstens einen Oberfläche einen Schritt der Bildung eines thermischen Oxids oder einer Nitridschicht auf der Oberfläche wenigstens der zweiten Platte, sowie nach dem Schritt a) einen Schritt des Entfernens des auf der Oberfläche gebildeten thermischen Oxids, beispielsweise mittels einer sauren Lösung.

8. Verfahren nach einem der Ansprüche 1 bis 7 in Kombination mit Anspruch 3, bei dem der Schritt d) erzielt wird durch Realisieren von zweiten Sägeschnitten (10) in der zweiten Fläche der zweiten Platte lotrecht zu den ersten Sägeschnitten (8), bis sie die ersten Sägeschnitte (8) treffen und ein Materialblock der zweiten Platte (P2) freigesetzt wird, der lotrecht zu der Oberfläche (6) angeordnet ist, wobei die zweiten Sägeschnitte vorzugsweise unter 45° zu den Kristallebenen der zweiten Platte orientiert sind.

9. Verfahren nach einem der Ansprüche 1 bis 7 in Kombination mit Anspruch 3, bei dem der Schritt d) erzielt wird durch Abdünnen der zweiten Platte (P102) ausgehend von ihrer zweiten Fläche, bis der oder die erste(n) Sägeschnitt(e) (108) getroffen wird und ein Materialblock der zweiten Platte (P102) freigesetzt wird, der lotrecht zur Oberfläche (106) angeordnet ist.

10. Verfahren zum Realisieren eines Trägers für wenigstens ein Substrat, wobei der Träger wenigstens eine Vertiefung umfasst, um das Substrat aufzunehmen, ausgehend von wenigstens einer ersten Platte (P201), einer zweiten Platte (P202), und einer dritten Platte (P203), die jeweils erste und zweite planparallele Flächen umfassen, umfassend die Schritte:
a) Begrenzen, ausschließlich auf der ersten planen Fläche der zweiten Platte (P202), wenigstens einer Oberfläche mittels einer Zone, die mit einer Fläche der ersten Platte (P201) eine Klebeenergie im Bereich der Schwachklebezone von weniger als 200 mJ/m2 aufweist, genannt Schwachklebezone, wobei die Oberfläche jene der zu realisierenden Vertiefung ist,
b) Inkontaktbringen der ersten Fläche der zweiten Platte (P202) mit der zweiten Fläche der ersten Platte (P201),
c) direktes Verkleben zwischen der ersten und der zweiten Fläche,
d) Entfernen des Bereichs der zweiten Platte (P202), der lotrecht zur ersten Oberfläche im Inneren der Schwachklebezone angeordnet ist, durch Ablösen der dritten Platte (P203), wobei das Verfahren vor dem Schritt a) einen Schritt des Zusammenfügens der zweiten Platte (P202) und der dritten Platte (P203) durch direkte Verklebung zwischen der zweiten Fläche der zweiten Platte (P202) und der ersten Fläche der dritten Platte (P203) umfasst, wobei die direkte Verklebung eine Verbindungsenergie bietet, die größer ist als die Verbindungsenergie zwischen der ersten Fläche der zweiten Platte (P202) und der zweiten Fläche der ersten Platte (P202) außerhalb der Schwachklebezone.

11. Verfahren nach Anspruch 10, umfassend vor dem Zusammenfügen der zweiten (P202) und der dritten (P203) Platte die Bildung einer Schicht aus thermischen Oxid an der Oberfläche wenigstens der zweiten (P202) und der dritten (P203) Platte, wobei die Verklebung zwischen der zweiten Fläche der zweiten Platte (P202) und einer ersten Fläche der dritten Platte (P203) vorzugsweise eine hydrophile Verklebung ist, und die Verklebung zwischen der ersten Fläche der zweiten Platte (P202) und der zweiten Fläche der ersten Platte (P201) vorzugsweise eine hydrophobe Verklebung ist.

12. Verfahren nach Anspruch 10 oder 11, umfassend nach dem Zusammenfügen der zweiten (P202) und der dritten (P203) Platte das Entfernen der Oxidschichten wenigstens der zweiten (P202) und der dritten (P203) Platte.

13. Verfahren nach Anspruch 10, 11 oder 12, bei dem die Schwachklebezone durch wenigstens einen ersten Sägeschnitt (208) gebildet wird, wobei der wenigstens eine erste Sägeschnitt vorzugsweise unter 45° zu den Kristallebenen der zweiten Platte orientiert ist.

14. Verfahren nach Anspruch 13, bei dem die ersten Sägeschnitte (208) eine Tiefe haben, die kleiner als die Dicke der zweiten Platte (P202) ist.

15. Verfahren nach einem der Ansprüche 10 bis 14, bei dem der Schritt d) erzielt wird durch Ausüben einer Separationskraft zwischen der ersten Fläche der dritten Platte (P203) und der zweiten Fläche der zweiten Platte (P202) an einem lateralen Ende des Stapels der zweiten (P202) und der dritten (P203) Platte.

16. Verfahren nach einem der Ansprüche 1 bis 15, bei dem während des Schritts a) mehrere Oberflächen begrenzt werden.

## Claims

1. A method for producing a holder of at least one substrate, where said holder comprises at least one cavity to hold said substrate, from at least one first plate (P1, P101) and one second plate (P2, P102), where each has first and second parallel flat faces, comprising the following steps:
a)
a1)delimitation only on the first flat face of the second plate (P2, P102) of at least one surface (6, 106) by means of an area having, with a face of the first plate (P1, P101), a bonding energy in the weak bonding area less than 200 mJ/m², called the weak bonding area,
a2) treatment of said surface (6, 106) in order that it has bonding properties reduced compared to those of the remainder of the first face of the second plate,
b) bringing the first face of the second plate (P2, P102) into contact with the second face of the first plate (P1, P101),
c) direct bonding between said first and second faces,
d) removal of the portion of the second plate (P2, P102) located directly below said surface inside the weak bonding area.

2. A method according to claim 1 wherein, in step c), there is no bonding in the weak bonding area.

3. A method according to claim 1 or 2, wherein the weak bonding area is formed by at least a first saw cut (8, 108), the at least a first saw cut being advantageously aligned at 45° to the crystalline planes of the second plate.

4. A method according to one of claims 1 to 3, wherein the treatment of said surface comprises a step of increasing the roughness of said surface, such that bonding with the second face of the first plate is prevented.

5. A method according to one of the claims 1 to 3, wherein the treatment of said surface (6) comprises a step of removal of the material from said surface so as to create a clearance between said surface and the first face of the first plate (P1).

6. A method according to claim 4 or 5, wherein the step of increasing the roughness or of removal of material to prevent contact is implemented by etching, for example with tetramethylammonium hydroxide.

7. A method according to one of claims 1 to 6, comprising, prior to step a) of delimitation of the at least one surface, a step of formation of a thermal oxide or a nitride layer on the surface of at least the second plate and, after step a), a step of removal of the thermal oxide formed on the surface, for example by means of an acid solution.

8. A method according to one of claims 1 to 7 in combination with claim 3, wherein step d) is obtained by making two saw cuts (10) in the second face of the second plate (P2) at right angles to the first saw cuts (8) until the first saw cuts (8) are reached, and in releasing a block of material of the second plate (P2) located vertically below the surface (6), the second saw cuts being advantageously aligned at 45° to the crystalline planes of the second a

9. A method according to one of claims 1 to 7 in combination with claim 3, wherein step d) is obtained by thinning the second plate (P102) from its second face until the first saw cut or saw cuts (108) is/are reached, and in releasing a block of material of the second plate (P102) located vertically below the surface (106).

10. A method for producing a holder of at least one substrate, where said holder comprises at least one cavity to hold said substrate, from at least one first plate (P201), one second plate (P202) and one third plate (P203), where each has first and second parallel flat faces, comprising the following steps:
a) delimitation only on the first flat face of the second plate (P202) of at least one surface by means of an area having, with a face of the first plate (P201), a bonding energy in the weak bonding area less than 200 mJ/m2, called the weak bonding area, said surface being the surface of the cavity to be made,
b) bringing the first face of the second plate (P202) into contact with the second face of the first plate (P201),
c) direct bonding between said first and second faces,
d) removal of the portion of the second plate (P202) located directly below said surface inside the weak bonding area, by separated the third plate (P203),
said method comprising, prior to step a), a step of assembly of the second plate (P202) and the third plate (P203) by direct bonding between the second face of the second plate (P202) and a first face of the third plate (P203), said direct bonding having bonding energy greater than the bonding energy between the first face of the second plate (P202) and the second face of the first plate (P202) outside the weak bonding area.

11. A method according to claim 10, comprising, prior to the assembly of the second (P202) and third (P203) plates, the formation of a thermal oxide layer on the surface of at least the second (P202) and third (P203) plates, the bonding between the second face of the second plate (P202) and a first face of the third plate (P203) being advantageously a hydrophilic bonding, and the bonding between the first face of the second plate (P202) and the second face of the first plate (P201) being advantageously a hydrophobic bonding.

12. A method according to one of claims 10 or 11, comprising, after the second (P202) and third (P203) plates have been assembled, the removal of the oxide layers of at least the second (P202) and third (P203) plates.

13. A method according to claim 10, 11 or 12, wherein the weak bonding area is made by at least one first saw cut (208), said at least one saw cut being advantageously aligned at 45° to the crystalline planes of the second plate.

14. A method according to claim 13, wherein the depth of the first saw cuts (208) is less than the thickness of the second plate (P202).

15. A method according to one of claims 10 to 14, wherein step d) is obtained by exerting a separation force between the first face of the third plate (P203) and the second face of the second plate (P202) at a lateral end of the stack of the second (P202) and third (P203) plates.

16. A method according to one of claims 1 to 15 wherein, in step a), several surfaces are delimited.
